# EUROPÄISCHE PATENTSCHRIFT

(11) **EP 2 859 783 B1**
(45) Veröffentlichungstag und Bekanntmachung des Hinweises auf die Patenterteilung: **17.05.2017**
(21) Anmeldenummer: 13726746.4
(22) Anmeldetag: 29.05.2013
(51) Int. Cl.: H05G 2/00

(54) **EUV-ANREGUNGSLICHTQUELLE MIT EINER LASERSTRAHLQUELLE UND EINER STRAHLFÜHRUNGSVORRICHTUNG ZUM MANIPULIEREN DES LASERSTRAHLS**
EUV EXCITATION LIGHT SOURCE WITH A LASER BEAM SOURCE AND A BEAM GUIDING DEVICE FOR MANIPULATING THE LASER BEAM
SOURCE DE LUMIÈRE D'EXCITATION UVE ÉQUIPÉE D'UNE SOURCE DE FAISCEAU LASER ET D'UN DISPOSITIF DE GUIDAGE DE FAISCEAU SERVANT À MANIPULER LE FAISCEAU LASER

(30) Priorität: 12.06.2012 DE 102012209837
(43) Veröffentlichungstag der Anmeldung: 15.04.2015
(73) Patentinhaber: TRUMPF Lasersystems for Semiconductor Manufacturing GmbH, 71254 Ditzingen (DE)
(72) Erfinder: LAMBERT, Martin, 71404 Korb (DE); SCHULZ, Joachim, 70839 Gerlingen (DE)
(74) Vertreter: Prüfer & Partner mbB Patentanwälte · Rechtsanwälte
(86) Internationale Anmeldenummer: PCT/EP2013/061056
(87) Internationale Veröffentlichungsnummer: WO 2013/186052

(56) Entgegenhaltungen:
- EP-A1- 0 858 249
- EP-A2- 1 492 394
- US-A1- 2006 215 712

## Beschreibung

Die Erfindung betrifft eine EUV-Anregungslichtquelle mit einer Laserstrahlquelle und einer Strahlführungsvorrichtung zum Manipulieren des Laserstrahls, insbesondere eine EUV-Anregungslichtquelle mit einer Strahlführungsvorrichtung zum Manipulieren zumindest eines getrennten Strahls des Laserstrahls.

Es sind Vorrichtungen zum Erzeugen von EUV- (Extreme UltraViolett-) Strahlung bekannt, die ein Target-Material, das z.B. Xenon, Lithium oder Zinn enthält, mit einem Laserstrahl, z.B. von einem CO₂-Laser, anregen, um EUV-Strahlung auszusenden.

Dokument WO 2011/162903 zeigt einen Laser, der das Target-Material in der entsprechenden Weise anregt, um als EUV-Anregungslichtquelle zu wirken. Um die Effizienz der Erzeugung des EUV-Lichts zu verbessern, werden Tröpfchen des Target-Materials zuerst von einem sogenannten Vorpuls ("pre-pulse") getroffen und dabei werden die Tröpfchen ausgeweitet, in Gas verwandelt, verdampft, oder in ein schwaches Plasma verwandelt. Das von dem "pre-pulse" vorbereitete Target-Material wird dann durch einen sogenannten Hauptpuls ("main-pulse") in Plasma umgewandelt und strahlt EUV-Licht aus. Fallweise werden als Lichtquellen für den "pre-pulse" und "main-pulse" verschiedene Laser verwendet, die dann beispielsweise mit Hilfe einer Optik, einem Strahlkombinator ("beam combiner"), auf einem gemeinsamen Strahlweg in einen gemeinsamen Verstärker eingeleitet werden.

Die verschiedenen Laser können auch Licht mit unterschiedlichen Wellenlängen ausstrahlen, wobei beim Einsatz von mehreren Lasern die Laserstrahlen mit den unterschiedlichen Wellenlängen durch chromatische Abbildungsfehler auf Fokusse in verschiedenen Abständen auf einer Achse des Laserstrahls fokussiert werden.

Dokument EP 0 858 249 A1 offenbart eine EUV-Anregungslichtquelle mit den Merkmalen des Oberbegriffs des Anspruchs 1.

Dokument US 2006/0215712 A1 zeigt eine EUV-Anregungslichtquelle mit zwei Laserstrahlquellen, deren Laserstrahlen über Strahlteiler getrennt werden und über Spiegel und fokussierende Einrichtungen auf einen Zielbereich geleitet werden.

In Dokument EP 1 492 394 A2 wird eine EUV-Anregungslichtquelle gezeigt, die eine Laserstrahlquelle und eine Strahlführungsvorrichtung mit einem Strahlteiler und einem Spiegel als optische Verzögerungseinrichtung. Ein "pre-pulse" und ein "main-pulse" werden dann jeweils durch Linsen auf einen Zielbereich fokussiert.

Der Erfindung liegt die Aufgabe zugrunde, eine EUV-Anregungslichtquelle bereitzustellen, die es ermöglicht, mindestens einen Laserstrahl so zu Manipulieren, dass verschiedene Fokusse des Laserstrahls erzeugt werden, die sich an unterschiedlichen Orten befinden.

Die Aufgabe wird durch eine EUV-Anregungslichtquelle gemäß Anspruch 1 gelöst. Weiterentwicklungen der Erfindung sind Gegenstand der Unteransprüche.

Durch das Aufteilen eines Laserstrahls durch eine Strahlführungsvorrichtung in mehrere getrennte Strahlen und das Manipulieren von zumindest einem der getrennten Strahlen des Laserstrahls besteht die Möglichkeit, mehrere Fokusse eines Laserstrahls in jeweils einem vorbestimmten Abstand an einem vorbestimmten Ort zu erzeugen, wobei die vorbestimmten Orte in den drei Raumdimensionen unterschiedlich sein können. Dadurch kann für eine EUV-Strahlungserzeugung, ein Fokus bzw. Brennpunkt für einen "pre-pulse" eingestellt werden, der von einem Fokus eines "main-pulse" verschieden ist. Somit kann ein Target-Material optimal bestrahlt werden, um ein Tröpfchen des Target-Materials, das durch den "pre-pulse" an einem ersten Ort vorbereitet wurde, an einem zweiten, optimalen Ort in seiner Bahn, die durch eine Anfangsrichtung und -geschwindigkeit, die Schwerkraft und eine Ablenkung durch den "pre-pulse" bestimmt ist, zu treffen und zum Ausstrahlen des EUV-Lichts anzuregen.

Die Erfindung wird anhand von Ausführungsbeispielen unter Bezugnahme auf die beigefügten Zeichnungen erläutert.
- Fig. 1: zeigt eine prinzipielle Darstellung einer EUV-Anregungslichtquelle mit einer ersten Ausführungsform einer Strahlführungsvorrichtung mit ebenen Spiegeln zum Manipulieren eines reflektierten getrennten Strahls eines Laserstrahls einer Laserstrahlquelle;
- Fig. 2: zeigt eine prinzipielle Darstellung der EUV-Anregungslichtquelle mit einer zweiten Ausführungsform der Strahlführungsvorrichtung zum Manipulieren von zwei Laserstrahlen von jeweils einer Laserstrahlquelle;
- Fig. 3: zeigt eine prinzipielle Darstellung der EUV-Anregungslichtquelle mit einer dritten Ausführungsform der Strahlführungsvorrichtung mit einem gekrümmten Spiegel;
- Fig. 4: zeigt eine prinzipielle Darstellung der EUV-Anregungslichtquelle mit einer vierten Ausführungsform der Strahlführungsvorrichtung, in der sowohl der reflektierte als auch ein transmittierter getrennter Strahl manipuliert wird; und
- Fig. 5: zeigt eine prinzipielle Darstellung eines Strahlengangs in einer Strahlführungsvorrichtung gemäß einer fünften Ausführungsform zum Kompensieren eines Polarisationsfehlers oder einer Phasenverschiebung.

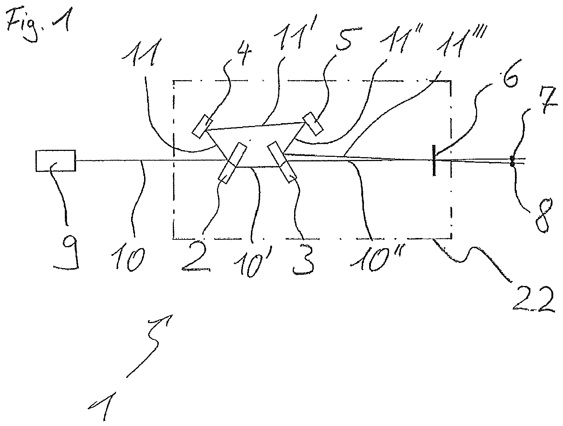

Fig. 1 zeigt eine erste Ausführungsform einer EUV-Anregungslichtquelle 1 mit einer Strahlführungsvorrichtung 22 zum Manipulieren eines Laserstrahls 10. Unter Manipulieren sind eine Veränderung einer Richtung und/oder eine Veränderung einer Divergenz eines Laserstrahls zu verstehen. Die Strahlführungsvorrichtung 22 weist einen Strahlteiler 2, einen ersten Spiegel 4, einen zweiten Spiegel 5 und einen Überlagerungsspiegel 3 auf. Weiterhin ist eine Linse als eine fokussierende Einrichtung 6 in der Strahlführungsvorrichtung 22 vorgesehen.

Der Strahlteiler 2 ist in dieser Ausführungsform mit teildurchlässigen Beschichtungen versehen. Dadurch wird ein auf den Strahlteiler 2 auftreffender Laserstrahl 10 aufgeteilt, und ein transmittierter getrennter Strahl 10' und ein reflektierter getrennter Strahl 11 werden erzeugt. Der erste Spiegel 4 und der zweite Spiegel 5 sind in dieser Ausführungsform plan bzw. eben ausgebildet und reflektieren einfallendes Licht vollständig. Der Überlagerungsspiegel 3 ist mit Beschichtungen versehen, die passend zu den Beschichtungen des Strahlteilers 2 sind. Dadurch wirkt der Überlagerungsspiegel 3 für Laserstrahlen, die auf einer Seite des Überlagerungsspiegels auftreffen, transmissiv und für Laserstrahlen, die auf der anderen Seite auftreffen, reflektiv. Die fokussierende Einrichtung 6 ist als Linse ausgebildet und erzeugt einen Fokus 7, 8 eines auf die Linse auftreffenden Laserstrahls 10", 11'''. Die fokussierende Einrichtung 6 kann alternativ auch als Spiegel oder ein System aus mehreren optischen Elementen ausgebildet sein.

In alternativen Ausführungsformen ist, abhängig von den geometrischen und optischen Vorgaben, nur ein Spiegel 4 vorgesehen, oder es sind mehr als zwei Spiegel 4, 5 vorgesehen.

Transmissive Elemente, wie zum Beispiel der Strahlteiler 2, der Überlagerungsspiegel 3 und die fokussierende Einrichtung 6 sind vorzugsweise aus Diamant hergestellt. Dadurch wird sichergestellt, dass der transmittierte Strahl durch thermische Effekte im transmissiven Element nicht oder nur geringfügig beeinflusst wird. Alternativ ist ein anderes geeignetes Material zu verwenden. Prinzipiell ist ZnSe als Substrat geeignet, in diesem Fall ist jedoch durch die sich ausbildenden Temperaturgradienten mit einer erheblichen Divergenzänderung im transmittierten Strahl zu rechnen.

Für die Erzeugung des Laserstrahls 10 ist eine Laserstrahlquelle 9, beispielsweise ein CO₂-Laser, vorgesehen. Die Laserstrahlquelle 9 wird durch eine nicht gezeigte Steuerungsvorrichtung so angesteuert, dass davon Laserstrahlimpulse mit einer Wellenlänge im infraroten Spektralbereich abgegeben werden. Die Laserstrahlquelle 9 weist im Wesentlichen einen Seed-Laser und Verstärkerstufen auf. Alternativ können, wie nachstehend beschrieben, auch mehrere Seed-Laser vorgesehen sein, deren Laserstrahlen in gemeinsamen Verstärkerstufen, oder alternativ in separaten Verstärkerstufen, verstärkt werden.

Der Laserstrahl 10 trifft auf den Strahlteiler 2 auf, wird dort geteilt, und der erste transmittierte getrennte Strahl 10' und der erste reflektierte getrennte Strahl 11 werden erzeugt. Das Verhältnis der Intensität des ersten transmittierten getrennten Strahls 10' zu der Intensität des ersten reflektierten getrennten Strahls 11 ist abhängig von den Beschichtungen des Strahlteilers 2. Üblicherweise ist eine Leistungsverteilung so festgelegt, dass die Leistung des transmittierten getrennten Strahls ungefähr 10% - 30% der Leistung des reflektierten getrennten Strahls beträgt.

Der erste transmittierte getrennte Strahl 10' trifft dann auf den Überlagerungsspiegel 3 auf und wird durch diesen transmittiert, so dass der zweite transmittierte getrennte Strahl 10" entsteht. Der zweite transmittierte getrennte Strahl 10" trifft dann auf die fokussierende Einrichtung 6 auf und wird dort auf den ersten Fokus 7 fokussiert.

Der erste reflektierte getrennte Strahl 11 wird an dem ersten Spiegel 4 reflektiert, so dass der zweite reflektierte getrennte Strahl 11' entsteht. Der zweite reflektierte getrennte Strahl 11' trifft auf den zweiten Spiegel 5 auf und wird dort auf den dritten reflektierten getrennten Strahl 11" reflektiert. Der dritte reflektierte getrennte Strahl 11" trifft dann auf den Überlagerungsspiegel 3 auf und wird dort in den vierten reflektierten getrennten Strahl 11''' reflektiert. Der vierte reflektierte getrennte Strahl 11''' trifft auf die fokussierende Einrichtung 6 auf und wird dort auf den zweiten Fokus 8 fokussiert.

Die Laserstrahlquelle 9, der Strahlteiler 2, der erste Spiegel 4, der zweite Spiegel 5 und der Überlagerungsspiegel 3 sind jeweils so ausgebildet und angeordnet, dass der erste Fokus 7 und der zweite Fokus 8 in dieser Ausführungsform den selben Abstand zu der fokussierenden Einrichtung 6 aufweisen, sich aber an einem anderen Ort befinden. Die Orte, an denen sich die Fokusse 7, 8 befinden, liegen hier auf einer Linie quer zu einer optischen Achse der die Fokusse 7, 8 bildenden Laserstrahlen.

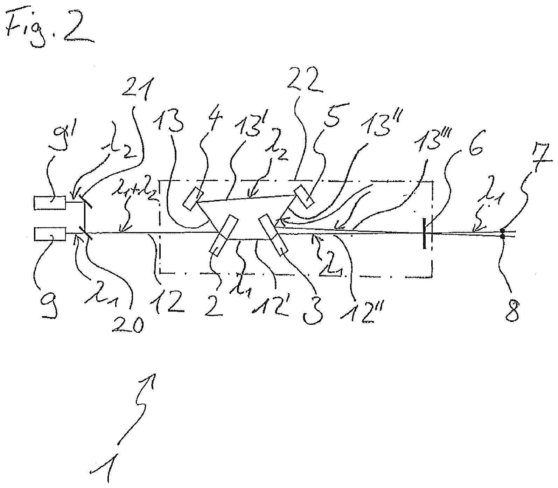

Fig. 2 zeigt eine zweite Ausführungsform der Strahlführungsvorrichtung 22. In dieser Ausführungsform sind zwei Laserstrahlquellen 9, 9' vorgesehen. Die Laserstrahlquelle 9 unterscheidet sich von der Laserstrahlquelle 9' dahingehend, dass sie Licht mit einer anderen Wellenlänge aussendet. Die Laserstrahlquelle 9 sendet einen Laserstrahl mit einer ersten Wellenlänge λ₁ aus und die Laserstrahlquelle 9' sendet einen Laserstrahl mit einer zweiten Wellenlänge λ₂ aus. Die Laserstrahlen werden durch optische Elemente 20, 21 zusammengeführt und bilden einen konzentrischen Laserstrahl 12. Alternativ werden die Laserstrahlen der Laserstrahlquellen 9, 9' auch direkt auf den Strahlteiler 2 gerichtet.

Der Strahlteiler 2 ist in dieser Ausführungsform so ausgebildet, dass er eine filternde Beschichtung aufweist, die einen Wellenlängenbereich im Wesentlichen reflektiert und einen anderen Wellenlängenbereich im Wesentlichen transmittiert. In dieser Ausführungsform wird der Laserstrahl mit dem Wellenlängenbereich λ₁ im Wesentlichen transmittiert und der Laserstrahl mit dem Wellenlängenbereich λ₂ im Wesentlichen reflektiert. Dadurch entstehen der erste transmittierte getrennte Strahl 12' und der erste reflektierte getrennte Strahl 13.

Der erste transmittierte getrennte Strahl 12' wird durch den Überlagerungsspiegel 3, der auch hier passend zu dem Strahlteiler 2 beschichtet ist, transmittiert und bildet einen zweiten transmittierten getrennten Strahl 12''. Der zweite transmittierte getrennte Strahl 12'' wird durch die fokussierende Einrichtung 6 fokussiert und ergibt dann den ersten Fokus 7.

Analog zu der ersten Ausführungsform wird in der zweiten Ausführungsform der erste reflektierte getrennte Strahl 13 dann ebenfalls an den Spiegeln 4 und 5 reflektiert, so dass der zweite reflektierte getrennte Strahl 13' und der dritte reflektierte getrennte Strahl 13" entstehen. Der dritte reflektierte getrennte Strahl 13" wird dann durch den Überlagerungsspiegel 3 in einem vierten reflektierten getrennten Strahl 13''' auf die fokussierende Einrichtung 6 reflektiert, und durch die fokussierende Einrichtung 6 wird der vierte reflektierte getrennte Strahl 13''' auf den zweiten Fokus 8 fokussiert.

Durch die Verwendung von zwei Laserstrahlquellen 9, 9' ist es möglich, sowohl zwei räumlich separierte Fokusse 7, 8 zu erzeugen, als auch durch eine entsprechende Ansteuerung zeitlich unterschiedliche Fokusse 7, 8 zu erzeugen, wobei die räumlich separierten Fokusse auch zu unterschiedlichen Zeiten erzeugt werden können.

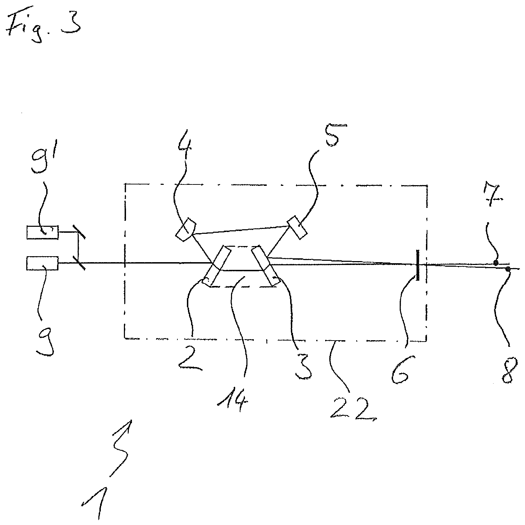

In Fig. 3 ist eine dritte Ausführungsform der Strahlführungsvorrichtung 22 gezeigt. Der Unterschied zu der in Fig. 2 gezeigten zweiten Ausführungsform liegt darin, dass der erste Spiegel 4 nicht plan, sondern gekrümmt ist. Durch die Krümmung des ersten Spiegels 4 wird die Divergenz des Laserstrahls verändert, so dass der durch die Spiegel 4, 5 reflektierte Laserstrahl mit einer zu dem durch den Strahlteiler 2 und den Überlagerungsspiegel 3 transmittierten Laserstrahl unterschiedlichen Divergenz auftrifft, so dass der zweite Fokus 8, im Vergleich zu den vorangehenden Ausführungsformen, zu der fokussierenden Einrichtung 6 einen anderen (hier: größeren) Abstand aufweist. Alternativ kann, in Abhängigkeit von der Krümmung des Spiegels, der besagte Abstand des zweiten Fokus zu der fokussierenden Einrichtung 6 auch geringer sein.

Alternativ kann der Abstand des Fokus zu der fokussierenden Einrichtung 6 auch dadurch variieren, dass sich der Fokus entlang einer Achse, die senkrecht zur optischen Achse der fokussierenden Einrichtung 6 verläuft, verschiebt.

In alternativen Ausführungen kann auch entweder nur der zweite Spiegel 5 gekrümmt sein oder beide Spiegel 4, 5 können gekrümmt sein. Darüber hinaus ist es alternativ nicht zwingend erforderlich, dass die Divergenz des Laserstrahls durch gekrümmte Spiegel verändert wird. Die Veränderung der Divergenz ist auch durch andere optische Elemente, beispielsweise Linsen, oder mehr als zwei Spiegel 4, 5 möglich.

Grundsätzlich wird in dieser Ausführungsform durch die Ausrichtung der Laserstrahlen der Laserstrahlquellen 9, 9', des Strahlteilers 2, der Spiegel 4, 5 und des Überlagerungsspiegels 3 die Ausrichtung des Laserstrahls nach dem Überlagerungsspiegel 3 und somit nach der fokussierenden Einrichtung 6 festgelegt und zumindest durch die Krümmung der Spiegel 4, 5 wird hier der Abstand des Fokus von der fokussierenden Einrichtung 6 festgelegt. Dadurch kann z.B. ein konzentrischer Strahl mit unterschiedlichen Divergenzen der getrennten Strahlen erzeugt werden (hier nicht gezeigt), oder (wie dargestellt) können die getrennten Strahlen nach dem Überlagerungsspiegel 3 einen Winkel zueinander einschließen. Bei einem konzentrischen Strahl können, in Abhängigkeit von der Divergenz der getrennten Strahlen, Fokusse in unterschiedlichen Abständen zu der fokussierenden Einrichtung 6 auf der Achse des konzentrischen Strahls erzeugt werden. Bei getrennten Strahlen, die nach der fokussierenden Einrichtung 6 auch einen Winkel zueinander einschließen, kann sowohl der Abstand des Fokus zu der fokussierenden Einrichtung 6 unterschiedlich sein als auch der Ort des Fokus so vorbestimmt werden, dass er nicht auf der Achse des anderen getrennten Strahls liegt. Dadurch kann eine räumliche Separierung der Fokusse zueinander in allen drei Raumrichtungen realisiert werden. Erfindungsgemäss ist der Zwischenraum zwischen dem Strahlteiler 2 und dem Überlagerungsspiegel 3 als ein erster geschlossener Raum 14 ausgebildet. Ein vorbestimmter Druck in dem ersten geschlossenen Raum 14, der durch eine Einrichtung zum Einstellen des Drucks (beispielsweise durch einen ansteuerbaren Druckregler), die von der Steuerungsvorrichtung angesteuert wird, eingestellt werden kann, kann relativ zur Umgebung verändert werden. Durch eine Veränderung des Drucks relativ zur Umgebung können die Krümmungen der reflektiven Flächen an dem Strahlteiler 2 und dem Überlagerungsspiegel 3 variiert werden, um so die Divergenz des reflektierten Strahls zu verändern, wodurch der Abstand des Fokus zu der fokussierenden Einrichtung 6 auch während des Betriebs verändert werden kann. Alternativ ist es auch möglich, dass nur der Strahlteiler 2 oder nur der Überlagerungsspiegel 3 den ersten geschlossenen Raum 14 begrenzen.

Ein optionales motorisches Verkippen der Spiegel 4, 5, wobei eine entsprechende Verkippungseinrichtung von der Steuerungsvorrichtung angesteuert wird, ist ebenfalls möglich, womit der Ort des Fokus 8 während des Betriebs verändert werden kann. In einer optionalen Kombination des motorischen Verkippens mit der Verstellung der Krümmung der Spiegel kann der Ort des Fokus 8 in allen drei Raumrichtungen ständig verändert werden.

Alternativ zu den in Fig. 2 gezeigten Laserstrahlen mit unterschiedlichen Wellenlängen λ₁ und λ₂ können die Laserstrahlen der Laserstrahlquellen 9 und 9' auch unterschiedlich polarisiert sein. Die Laserstrahlen werden dann in Abhängigkeit von dem Polarisationszustand transmittiert oder reflektiert, so dass die entsprechenden getrennten Strahlen erzeugt werden. Die so entstandenen getrennten Strahlen mit unterschiedlicher Polarisation werden dann analog zu den in Fig. 2 oder Fig. 3 gezeigten Laserstrahlen 12, 13 manipuliert.

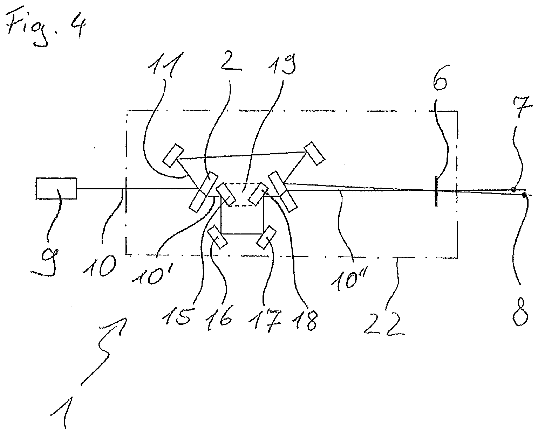

In Fig. 4 ist eine Ausführungsform der Strahlführungsvorrichtung 22 gezeigt, in der sowohl der erste reflektierte getrennte Strahl 11 als auch der erste transmittierte getrennte Strahl 10' manipuliert werden. Die getrennten Strahlen 10', 11 werden auch hier durch den Strahlteiler 2 erzeugt. Wie oben angegeben, kann der Laserstrahl 10 der Laserstrahlquelle 9 (oder, alternativ, mehrerer Laserstrahlquellen 9, 9') unter Ausnutzung von verschiedenen Eigenschaften des Laserstrahls 10 geteilt werden.

Für das Manipulieren des ersten transmittierten getrennten Strahls 10' sind hier ein dritter Spiegel 15, ein vierter Spiegel 16, ein fünfter Spiegel 17 und ein sechster Spiegel 18 vorgesehen. Einer oder mehrere der Spiegel 15, 16, 17, 18 können alternativ auch durch Linsen ersetzt werden. Außerdem sind nicht zwingen vier Spiegel 15, 16, 17, 18 erforderlich. Es kann alternativ auch eine andere geeignete Anzahl vorgesehen werden.

Der erste transmittierte getrennte Strahl 10' wird durch den dritten Spiegel 15 reflektiert und abgelenkt und, analog zu den oben beschriebenen Ausführungsformen, wird der erste transmittierte getrennte Strahl 10' manipuliert. Dadurch können seine Richtung und seine Divergenz verändert werden, um den ersten Fokus 7 an einem vorbestimmten Ort in einem vorbestimmten Abstand von der fokussierenden Einrichtung 6 zu erzeugen.

Auch hier ist optional ein Vorsehen eines zweiten geschlossenen Raums 19 in einem Zwischenraum zwischen dem dritten Spiegel 15 und dem sechsten Spiegel 18 (wie gezeigt), oder alternativ auch zwischen anderen von den Spiegeln 15, 16, 17, 18 möglich, oder nur ein Spiegel, der den zweiten geschlossenen Raum 19 begrenzt, ist möglich. In dem zweiten geschlossenen Raum 19 kann ein vorbestimmter Druck zu der Umgebung eingestellt und verändert werden. Somit kann dadurch die Divergenz des auf die fokussierende Einrichtung 6 auftreffenden getrennten Strahls 10'' verändert werden und dadurch kann der Abstand des Fokus 7 zu der fokussierenden Einrichtung 6 verändert werden.

Durch ein optionales motorisches Verkippen eines oder mehrerer der Spiegel 15, 16, 17, 18 kann die Strahlrichtung des auf die fokussierende Einrichtung 6 auftreffenden getrennten Strahls 10'' und durch Einstellen der Krümmung eines oder mehrerer der Spiegel 15, 16, 17, 18 kann der Abstands des Fokus 7 zu der fokussierenden Einrichtung 6 eingestellt werden, und somit der Ort des Fokus 7 eingestellt werden.

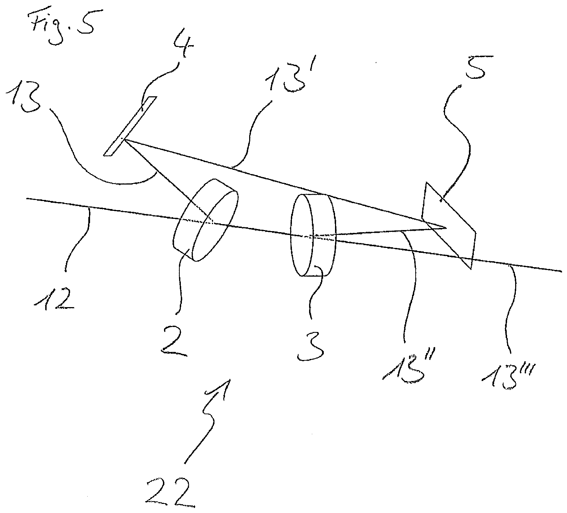

Fig. 5 zeigt eine prinzipielle Darstellung eines Strahlengangs in einer Strahlführungsvorrichtung 22 gemäß einer fünften Ausführungsform, um Polarisationsfehler oder eine Phasenverschiebung zu kompensieren.

Wenn die transmittierten Strahlen nicht rein linear polarisiert sind, wobei eine Polarisationsebene des linear polarisierten Laserstrahls in der Umlenkebene liegt, entstehen Polarisationsfehler. Im Fall willkürlicher Polarisationsebenen oder insbesondere in dem Fall einer zirkularen Polarisation erhält ein transmittierter Strahl eine systematisch von der Beschichtung abhängige Phasenverschiebung der beiden senkrecht und parallel zu der Umlenkebene (s- gegenüber p-Polarisation) auftreffenden Polarisationsanteile. Die systematische Phasenverschiebung tritt sowohl für transmittierte als auch für reflektierte Strahlen auf.

Der Strahlteiler 2 in Fig. 5 ist so angeordnet, dass eine Ebene, die durch den Laserstrahl 12 und den ersten reflektierten getrennten Laserstrahl 13 gebildet wird, senkrecht zu einer Ebene, die durch den dritten, an dem zweiten Spiegel 5 reflektierten getrennten Strahl 13'' und dem vierten, an dem Überlagerungsspiegel 3 reflektierten getrennten Strahl 13''' gebildet wird, angeordnet ist. Dabei ist wesentlich, dass die beiden Ebenen senkrecht zueinander stehen, so dass die p- (s-) Polarisationsanteile des einfallenden Laserstrahls 12 einmal als p-(s-)Polarisation und einmal als s-(p-)Polarisation durch die beiden optischen Elemente 2 und 3 hindurchtreten. In der Summe erhalten also beide Polarisationsanteile die gleiche Phasenschiebung, so dass der relative Phasenfehler ausgeglichen wird. Die Polarisation des transmittierten Anteils des Laserstrahls 13''' bzw. des transmittierten getrennten Strahls ist also gleich der Polarisation des einfallenden Laserstrahls 12.

Die systematische Phasenschiebung tritt auch für die reflektierten Laserstrahlen auf. Durch eine geeignete Wahl der Umlenkwinkel an einem oder mehreren der reflektierenden optischen Elemente 2, 3, 4, 5 und/oder durch die Verwendung eines oder mehrerer weiterer optischer Elemente im Strahlengang eines oder mehrerer der reflektierten getrennten Strahlen 13, 13' und 13'' zwischen den optischen Elementen 2 und 3 kann die Phasenschiebung auch für den reflektierten Anteil des Laserstrahls 13''' bzw. den reflektierten getrennten Strahl kompensiert werden.

Im Betrieb wird durch die EUV-Anregungslichtquelle 1 ein Laserstrahl zum Erzeugen einer EUV-(Extreme Ultra-Violette) Strahlung abgestrahlt. Durch zwei Seed-Laser werden in der EUV-Anregungslichtquelle 1 jeweils Laserstrahlen mit einer Wellenlänge λ₁ von 10,59 µm und λ₂ von 10,26 µm erzeugt. Die Laserstrahlen werden vor einer ersten Verstärkerstufe überlagert und in den Verstärkerstufen verstärkt. Die verstärkten Laserstrahlen 10 treffen dann auf den Strahlteiler 2, der so ausgeführt ist, dass der Laserstrahl mit der einen Wellenlänge reflektiert wird, und der Laserstrahl mit der anderen Wellenlänge transmittiert wird. Beispielsweise wird der Laserstrahl mit der größeren Wellenlänge transmittiert und der Laserstrahl mit der kleineren Wellenlänge reflektiert. Der transmittierte Strahl 10' trifft dann auf den Überlagerungsspiegel 3, wird dort transmittiert und trifft auf die fokussierende Einrichtung 6, die den Laserstrahl auf den ersten Fokus 7 fokussiert. Der erste reflektierte Strahl 11 wird durch die Spiegel 4, 5 reflektiert und trifft auf den Überlagerungsspiegel 3, von dem er zu der fokussierenden Einrichtung 6 umgelenkt wird, die den Laserstrahl auf den zweiten Fokus 8 fokussiert. Der Seed-Laser, der den Laserstrahl mit λ = 10,26 µm abgibt, wird so angesteuert, dass ein "pre-pulse" aus der EUV-Anregungslichtquelle 1 abgegeben wird, der ein auf einer parabelförmigen Bahn, quer zu den optischen Achsen der die Fokusse bildenden Laserstrahlen, bewegtes Zinntröpfchen in einem ersten Fokus 7 in einer zeitlich abhängigen Position am Ort A zum Zeitpunkt A trifft. Der "pre-pulse" weist eine gemittelte Leistung von ca. 3,5 kW auf. Dadurch wird das Zinntröpfchen deformiert, erhitzt und expandiert. Dann wird der Seed-Laser, der den Laserstrahl mit λ = 10,59 µm abgibt, angesteuert, so dass ein "main-pulse" abgegeben wird. Während sich das expandierte Zinntröpfchen weiterbewegt, wird es in dem zweiten Fokus 8 in einer zeitlich abhängigen Position am Ort B zum Zeitpunkt B durch den "main-pulse" zum Plasmaleuchten angeregt. Der "main-pulse" weist eine gemittelte Leistung von 35 kW auf.

Das dabei entstehende Licht mit 13,5 nm wird dann beispielsweise für eine Belichtung von Wafern für eine Halbleiterherstellung verwendet. Wesentlich für eine Erzeugung und Optimierung der Erzeugung der EW-Strahlung ist, dass sowohl der zeitliche Abstand zwischen dem Zeitpunkt A und dem Zeitpunkt B als auch die räumliche Lage des Orts A zum Ort B genau festgelegt werden, um das Zinntröpfchen zum Plasmaleuchten anzuregen. Eine feste Einstellung der zeitlich abhängigen Positionen der Fokusse erfolgt entweder mit empirisch, also mit im Voraus beispielsweise durch Messungen, ermittelten erforderlichen Werten durch ein manuelles Einstellen der Spiegel. Alternativ ist ein System zur Erzeugung des EUV-Lichts, das die EUV-Anregungslichtquelle 1 enthält, mit Erfassungseinrichtungen versehen, die sowohl den zeitlich abhängigen Ort der Zinntröpfchen als auch die zeitlich abhängigen Orte der Fokusse des "pre-pulse" und "main-pulse", beispielsweise über eine Erfassung einer Effektivität, erfassen, und über die erfassten Werte werden durch die Steuerungsvorrichtung die zeitlich abhängigen, optimalen Positionen der Fokusse ermittelt und an die Verstellmittel zum Einstellen der Orte der Fokusse weitergegeben, so dass die Zinntröpfchen durch den "pre-pulse" und "main-pulse" möglichst genau getroffen werden. Die Erfassung der Effektivität kann auch über eine Erfassung einer Intensität des abgestrahlten EUV-Lichts erfolgen.

Alternativ kann die Position der Zinntröpfchen auch anhand des Anfangszeitpunkts der Bewegung der Zinntröpfchen entlang seiner Bahnkurve und seiner Bahngeschwindigkeit berechnet werden, wenn die Bahnkurve bekannt ist.

Alternativ ist auch die Verwendung nur eines Seed-Lasers möglich, wobei der Seed-Laserstrahl dann mit einem verstellbaren Spiegel umgelenkt wird. Jedoch ist der zeitliche Abstand zwischen dem "pre-pulse" und dem "main-pulse" sehr gering (ca. 1 µs).

In einer alternativen Variante wird der Laserstrahl von sowohl einem CO₂-Laser (in Fig. 2 als 9' dargestellt) als auch von einem YAG-Laser (in Fig. 2 als 9 dargestellt) in die Strahlführungsvorrichtung 22 eingeleitet. Das Licht von dem CO₂-Laser, der eine Hauptleistung von ca. 35 kW erbringt, und dem YAG-Laser, der eine Leistung von ca. 500 W erbringt, wird auf eine Scheibe aus Quarzglas als das optische Element 20 gerichtet. Das Quarzglas ist reflektiv für den Laserstrahl des CO₂-Lasers und transmissiv für den Laserstrahl des YAG-Lasers. Der Lichtstrahl des CO₂-Lasers kann jedoch, anders als in Fig. 2 dargestellt, auch, ohne durch das optische Element 21 umgelenkt zu werden, direkt auf das optische Element 20 gerichtet sein.

Die beschriebenen Ausführungsformen sind nicht beschränkend und können miteinander kombiniert werden, um eine optimale Anregung eines Target-Materials zum Ausstrahlen des EUV-Lichts zu erlangen. Die Strahlführung kann alternativ weitere Elemente enthalten, die nicht in einer der beschriebenen Ausführungsformen enthalten sind.

## Patentansprüche

1. EUV-Anregungslichtquelle (1) mit
mindestens einer Laserstrahlquelle (9, 9') zum Aussenden mindestens eines Laserstrahls (10, 12) und
einer Strahlführungsvorrichtung (22) zum Manipulieren des mindestens einen Laserstrahls (10, 12), aufweisend:
mindestens einen Strahlteiler (2) zum Erzeugen von mindestens zwei getrennten Strahlen (10', 11, 12', 13) aus dem mindestens einen Laserstrahl (10, 12),
mindestens einen Spiegel (4, 5, 15, 16, 17, 18) oder mindestens eine Linse zum Manipulieren von mindestens einem der getrennten Strahlen (10', 11, 12', 13),
einen Überlagerungsspiegel (3) zum Überlagern der mindestens zwei getrennten Strahlen (10'', 11''', 12'', 13'''), und
eine fokussierende Einrichtung (6) zum Erzeugen eines jeweiligen Fokus (7, 8) der zwei getrennten Strahlen (10'', 11''', 12'', 13'''), **dadurch gekennzeichnet, dass** mindestens ein erster geschlossener Raum (14) vorgesehen ist, der mindestens von einem von dem Strahlteiler (2) und dem Überlagerungsspiegel (3) begrenzt wird, und eine Einrichtung zum Einstellen eines vorbestimmten Drucks in dem erstem geschlossenen Raum (14) vorgesehen ist, wobei durch eine Veränderung des vorbestimmten Drucks eine Krümmung des Strahlteilers (2) und/oder des Überlagerungsspiegels (3) verändert wird.

2. EUV-Anregungslichtquelle (1) gemäß Anspruch 1, wobei der Strahlteiler (2) ein teildurchlässiger Spiegel ist, der eine Beschichtung aufweist, die für einen Teil des mindestens einen der Laserstrahlen (10, 12) reflektierend ist und für einen weiteren Teil des mindestens einen der Laserstrahlen (10, 12) transmittierend ist.

3. EUV-Anregungslichtquelle (1) gemäß einem der vorangehenden Ansprüche, wobei mindestens einer der Spiegel (4, 5, 15, 16, 17, 18) plan ist.

4. EUV-Anregungslichtquelle (1) gemäß einem der Ansprüche 1 oder 2, wobei mindestens einer der Spiegel (4, 5, 15, 16, 17, 18) gekrümmt ist.

5. EUV-Anregungslichtquelle (1) gemäß einem der vorangehenden Ansprüche, wobei der mindestens eine Strahlteiler (2), der mindestens eine Spiegel (4, 5, 15, 16, 17, 18) oder die mindestens eine Linse, der Überlagerungsspiegel (3) und die fokussierende Einrichtung (6) so ausgebildet und angeordnet sind, dass sich der Fokus (7, 8) von einem der getrennten Strahlen (10'', 12'', 11''', 13''') an einem vorbestimmten Ort befindet.

6. EUV-Anregungslichtquelle (1) gemäß einem der vorangehenden Ansprüche, wobei der mindestens eine Strahlteiler (2), der mindestens eine Spiegel (4, 5, 15, 16, 17, 18) oder die mindestens eine Linse, der Überlagerungsspiegel (3) und die fokussierende Einrichtung (6) so ausgebildet und angeordnet sind, dass sich ein erster Fokus (7) des einen der getrennten Strahlen (10'', 12'') an einem anderen Ort als der zweite Fokus (8) des anderen der getrennten Strahlen (11''', 13''') befindet.

7. EUV-Anregungslichtquelle (1) gemäß einem der vorangehenden Ansprüche, wobei sich der erste Fokus (7) und der zweite Fokus (8) auf einer Linie befinden, die quer zu optischen Achsen der die Fokusse (7, 8) bildenden getrennten Strahlen (10'', 11''', 12'', 13''') liegt.

8. EUV-Anregungslichtquelle (1) gemäß einem der vorangehenden Ansprüche, wobei zumindest ein transmissives Element (2, 3, 6) aus Diamant bestehen.

9. EUV-Anregungslichtquelle (1) gemäß einem der vorangehenden Ansprüche, wobei mindestens ein zweiter geschlossener Raum (19) vorgesehen ist, der mindestens von einem der Spiegel (4, 5, 15, 16, 17, 18) begrenzt wird, und eine Einrichtung zum Einstellen eines vorbestimmten Drucks in dem zweiten geschlossenen Raum (19) vorgesehen ist, wobei durch eine Veränderung des vorbestimmten Drucks eine Krümmung des mindestens einen der Spiegel (4, 5, 15, 16, 17, 18) verändert wird.

10. EUV-Anregungslichtquelle (1) gemäß einem der vorangehenden Ansprüche, wobei der Strahlteiler (2) ein teildurchlässiger Spiegel ist, der eine filternde Beschichtung aufweist, die für einen Wellenlängenbereich transmissiv ist, und für einen anderen Wellenlängenbereich reflektierend ist.

11. EUV-Anregungslichtquelle (1) gemäß Anspruch 10 mit mindestens zwei Laserstrahlquellen (9, 9'), wobei die Laserstrahlquellen (9, 9') Laserstrahlen mit unterschiedlichen Wellenlängen (λ₁, λ₂) ausstrahlen.

12. EUV-Anregungslichtquelle (1) gemäß einem der Ansprüche 1 bis 9 , wobei der Strahlteiler (2) ein teildurchlässiger Spiegel ist, der eine filternde Beschichtung aufweist, die für einen Polarisationszustand des mindestens einen Laserstrahls (12) reflektierend ist und ein reflektierter getrennter Strahl (13) gebildet wird, und für einen anderen Polarisationszustand des mindestens einen Laserstrahls (10) durchlässig ist und ein transmittierter getrennter Strahl (12') entsteht.

13. EUV-Anregungslichtquelle (1) gemäß Anspruch 12, wobei der auf den Strahlteiler (2) auftreffende Laserstrahl (12) und der von dem Strahlteiler (2) reflektierte getrennte Strahl (13) in einer ersten Ebene angeordnet sind, und mindestens zwei Spiegel (4, 5) oder Linsen so angeordnet sind, dass ein von den Spiegeln (4, 5) oder Linsen manipulierter auf den Überlagerungsspiegel (3) auftreffender reflektierter getrennter Strahl (13') und der von dem Überlagerungsspiegel (3) reflektierte getrennte Strahl (13''') in einer zweiten Ebene angeordnet sind, und die erste Ebene und die zweite Ebene senkrecht zueinander sind.

14. EUV-Anregungslichtquelle (1) gemäß Anspruch 12 oder 13 mit mindestens zwei Laserstrahlquellen (9, 9'), wobei die Laserstrahlquellen (9, 9') Laserstrahlen mit unterschiedlicher Polarisation ausstrahlen.

15. EUV-Anregungslichtquelle (1) gemäß Anspruch 11 oder 14, wobei die Laserstrahlquellen (9, 9') separat voneinander ansteuerbar sind.

16. EUV-Anregungslichtquelle (1) gemäß einem der vorangehenden Ansprüche, wobei das Manipulieren eine Veränderung der Richtung eines Laserstrahls (10, 12) umfasst.

17. EUV-Anregungslichtquelle (1) gemäß einem der vorangehenden Ansprüche, wobei das Manipulieren eine Veränderung der Divergenz eines Laserstrahls (10,12) umfasst.

18. Verfahren zum Erzeugen von getrennten Strahlen mit einer EUV-Anregungslichtquelle (1) gemäß einem der vorangehenden Ansprüche, wobei das Verfahren folgende Schritte aufweist:
Erfassen von zeitlich abhängigen Positionen eines Target-Materials für einen "pre-pulse" und einen "main-pulse";
Einstellen der Strahlführungsvorrichtung (22) so, dass sich der jeweilige Fokus (7, 8) der zwei getrennten Strahlen (10'', 11''', 12'', 13''') im Wesentlichen in den zeitlich abhängigen Positionen befindet; Ansteuern der Laserstrahlquelle (9) so, dass der mindestens eine Laserstrahl (10, 12) den ersten Fokus (7) und zweiten Fokus (8) zu einem Zeitpunkt erzeugt, in dem sich das Target-Material im Wesentlichen in der jeweiligen zeitlich abhängigen Position befindet.

19. Verfahren gemäß Anspruch 18, wobei die zeitlich abhängigen Positionen empirisch ermittelt werden und die zeitlich abhängigen Positionen durch die Strahlführungsvorrichtung (22) fest eingestellt werden.

20. Verfahren gemäß Anspruch 18, wobei die zeitlich abhängigen Positionen während eines Betriebs der EUV-Anregungslichtquelle (1) ermittelt werden und durch eine Steuerungsvorrichtung die Strahlführungsvorrichtung (22) eingestellt wird und die mindestens eine Laserstrahlquelle (9) angesteuert wird.

## Claims

1. EUV excitation light source (1) having
at least one laser beam source (9, 9') for emitting at least one laser beam (10, 12) and
a beam guide device (22) for manipulating the at least one laser beam (10, 12) comprising:
at least one beam splitter (2) for generating at least two separated beams (10', 11, 12', 13) from the at least one laser beam (10, 12),
at least one mirror (4, 5, 15, 16, 17, 18) or at least one lens for manipulating at least one of the separated beams (10', 11, 12', 13),
a superposition mirror (3) for superposing the at least two separated beams (10'', 11''', 12'', 13''') and
a focusing appliance (6) for generating a respective focus (7, 8) of the two separated beams (10'', 11''', 12'', 13'''),
**characterized in that**
at least one first enclosed space (14) that is delimited at least by one of the beam splitters (2) and the superposition mirror (3) is provided, and a device for adjusting a predetermined pressure in the first enclosed space (14) is provided, wherein a curvature of the beam splitter (2) and/or of the superposition mirror (3) is modified by a modification of the predetermined pressure.

2. EUV excitation light source (1) according to claim 1, wherein the beam splitter (2) is a partially transparent mirror comprising a coating being reflective for a proportion of the at least one of the laser beams (10, 12) and being transmitting for a further proportion of the at least one of the laser beams (10, 12).

3. EUV excitation light source (1) according to anyone of the preceding claims, wherein at least one of the mirrors (4, 5, 15, 16, 17, 18) is flat.

4. EUV excitation light source (1) according to anyone of the claims 1 or 2, wherein at least one of the mirrors (4, 5, 15, 16, 17, 18) is curved.

5. EUV excitation light source (1) according to anyone of the preceding claims, wherein the at least one beam splitter (2), the at least one mirror (4, 5, 15, 16, 17, 18) or the at least one lens, the superposition mirror (3) and the focusing appliance (6) are designed and arranged such that the focus (7, 8) of one of the separated beams (10'', 12'', 11''', 13''') is located at a predetermined location.

6. EUV excitation light source (1) according to anyone of the preceding claims, wherein the at least one beam splitter (2), the at least one mirror (4, 5, 15, 16, 17, 18) or the at least one lens, the superposition mirror (3) and the focusing appliance (6) are designed and arranged such that a first focus (7) of one of the separated beams (10'', 12'') is located at another location than the second focus (8) of the other of the separated beams (11''', 13''').

7. EUV excitation light source (1) according to anyone of the preceding claims, wherein the first focus (7) and the second focus (8) are located on a line being transverse with respect to optical axes of the separated beams (10'', 11''', 12'', 13''') that are generating the focuses (7, 8).

8. EUV excitation light source (1) according to anyone of the preceding claims, wherein at least one transmitting member (2, 3, 6) is made of diamond.

9. EUV excitation light source (1) according to anyone of the preceding claims, wherein at least one second enclosed space (19) delimited by at least one of the mirrors (4, 5, 15, 16, 17, 18) is provided, and a device for adjusting a predetermined pressure in the second enclosed space (19) is provided, wherein a curvature of the at least one of the mirrors (4, 5, 15, 16, 17, 18) is changed by a change of the predetermined pressure.

10. EUV excitation light source (1) according to anyone of the preceding claims, wherein the beam splitter (2) is a partially transparent mirror comprising a filtering coating that is transmitting for one wavelength range and is reflecting for another wavelength range.

11. EUV excitation light source (1) according to claim 10 having at least two laser beam sources (9, 9'), wherein the laser beam sources (9, 9') emit laser beams having different wavelengths (λ₁, λ₂).

12. EUV excitation light source (1) according to any of the claims 1 to 9, wherein the beam splitter (2) is a partially transparent mirror comprising a filtering coating that is reflecting for one condition of polarisation of the at least one laser beam (12) and a reflected separated beam (13) is generated, and that is transmitting for another condition of polarization of the at least one laser beam (10) and a transmitted separated beam (12') emerges.

13. EUV excitation light source (1) according to claim 12, wherein the laser beam (12) impinging on the beam splitter (2) and the separated beam (13) reflected by the beam splitter (2) are arranged in a first plane, and at least two mirrors (4, 5) or lenses are arranged such that a reflected separated beam (13''), manipulated by the mirrors (4, 5) or lenses, impinging on the superposition mirror (3) and the separated beam (13''') reflected by the superposition mirror (3) are arranged in a second plane, and the first plane and the second plane are perpendicular with respect to each other.

14. EUV excitation light source (1) according to claim 12 or 13 having at least two laser beam sources (9, 9'), wherein the laser beam sources (9, 9') emit laser beams having different polarisations.

15. EUV excitation light source (1) according to claim 11 or 14, wherein the laser beams sources (9, 9') are controllable separately from each other.

16. EUV excitation light source (1) according to anyone of the preceding claims, wherein manipulating includes a change of the direction of a laser beam (10, 12).

17. EUV excitation light source (1) according to anyone of the preceding claims, wherein manipulating includes a change of a divergence of a laser beam (10, 12).

18. Method for generating separated beams by means of a EUV excitation light source (1) according to anyone of the preceding claims, wherein the method comprises following steps:
detecting timely dependent locations of a target material for a "pre-pulse" and for a "main-pulse";
adjusting the beam guide device (22) such that the respective focus (7, 8) of the two separated beams (10'', 11''', 12'', 13''') is located primarily at the timely dependent locations;
controlling the laser beam source (9) such that the at least one laser beam (10, 12) generates the first focus (7) and the second focus (8) at a time at which the target material is located primarily at the respective timely dependent location.

19. Method according to claim 18, wherein the timely dependent locations are empirically determined and the timely dependent locations are fixedly adjusted by means of the beam guide device (22).

20. Method according to claim 18, wherein the timely dependent locations are determined during operation of the EUV excitation light source (1) and, by a control device, the beam guide device (22) is adjusted and the at least one laser beam source (9) is controlled.

## Revendications

1. Source de lumière d'excitation EUV (1) comprenant :
- au moins une source de faisceau laser (9, 9') destinée à la transmission d'au moins un faisceau laser (10, 12) et
- un dispositif de guidage de faisceau (22) destiné à la manipulation de l'au moins un faisceau laser (10, 12), présentant :
- au moins un diviseur de faisceau (2) destiné à la génération d'au moins deux faisceaux (10', 11, 12', 13) séparés à partir de l'au moins un faisceau laser (10, 12) ;
- au moins un miroir (4, 5, 15, 16, 17, 18) ou au moins une lentille destiné(e) à la manipulation de l'au moins un des faisceaux (10', 11, 12', 13) séparés ;
- un miroir de superposition (3) destiné à la superposition des au moins deux faisceaux (10'', 11''', 12'', 13''') séparés ; et
- un mécanisme de focalisation (6) destiné à la génération d'un foyer (7, 8) respectif des deux faisceaux (10'', 11''',12'', 13''') séparé ;
**caractérisée en ce que**
au moins une première chambre (14) fermée est prévue, laquelle est délimitée par l'au moins un des diviseurs de faisceau (2) et par le miroir de superposition (3) et **en ce qu'**un mécanisme destiné au réglage d'une pression prédéterminée est prévu dans la première chambre fermée (14), dans laquelle une courbure du diviseur de faisceau (2) et/ou du miroir de superposition (3) est altérée par une modification de la pression prédéterminée.

2. Source de lumière d'excitation EUV (1) selon la revendication 1, dans laquelle le diviseur de faisceau (2) est un miroir en partie transparent, lequel présente un revêtement qui est réfléchissant pour une partie de l'au moins un des faisceaux laser (10, 12) et est transmissif pour une autre partie de l'au moins un des faisceaux laser (10, 12).

3. Source de lumière d'excitation EUV (1) selon l'une des revendications précédentes, dans laquelle l'au moins un des miroirs (4, 5, 15, 16, 17, 18) est plan.

4. Source de lumière d'excitation EUV (1) selon l'une des revendications 1 ou 2, dans laquelle l'au moins un des miroirs (4, 5, 15, 16, 17, 18) est courbe.

5. Source de lumière d'excitation EUV (1) selon l'une des revendications précédentes, dans laquelle l'au moins un diviseur de faisceau (2), l'au moins un miroir (4, 5, 15, 16, 17, 18) ou l'au moins une lentille, le miroir de superposition (3) et le mécanisme de focalisation (6) sont conçus et disposés de telle sorte que le foyer (7, 8) de l'un des faisceaux (10'', 12'', 11''', 13''') séparés se trouve à un emplacement prédéterminé.

6. Source de lumière d'excitation EUV (1) selon l'une des revendications précédentes, dans laquelle l'au moins un diviseur de faisceau (2), l'au moins un miroir (4, 5, 15, 16, 17, 18) ou l'au moins une lentille, le miroir de superposition (3) et le mécanisme de focalisation (6) sont conçus et disposés de telle sorte qu'un premier foyer (7) de l'un des faisceaux (10'', 12'') séparés se trouve à un autre emplacement que le deuxième foyer (8) de l'autre des faisceaux (11''', 13''') séparés.

7. Source de lumière d'excitation EUV (1) selon l'une des revendications précédentes, dans laquelle le premier foyer (7) et le deuxième foyer (8) se trouvent sur une ligne, laquelle se trouve à la perpendiculaire des axes optiques des faisceaux (10'', 11''',12'', 13''') séparés formant les foyers (7, 8).

8. Source de lumière d'excitation EUV (1) selon l'une des revendications précédentes, dans laquelle tout au moins un élément (2, 3, 6) transmissif est composé de diamant.

9. Source de lumière d'excitation EUV (1) selon l'une des revendications précédentes, dans laquelle au moins une deuxième chambre (19) fermée est prévue, laquelle est délimitée au moins par l'un des miroirs (4, 5, 15, 16, 17, 18) et dans laquelle un mécanisme destiné au réglage d'une pression prédéterminée est prévu dans la deuxième chambre (19) fermée, dans laquelle une courbure de l'au moins un des miroirs (4, 5, 15, 16, 17, 18) est altérée par une modification de la pression prédéterminée.

10. Source de lumière d'excitation EUV (1) selon l'une des revendications précédentes, dans laquelle le diviseur de faisceau (2) est un miroir en partie transparent qui présente un revêtement filtrant, lequel est transmissif pour une plage de longueur d'onde et lequel est réfléchissant pour une autre plage de longueur d'onde.

11. Source de lumière d'excitation EUV (1) selon la revendication 10 avec au moins deux sources de faisceau laser (9, 9'), dans laquelle les sources de faisceau laser (9, 9') émettent des faisceaux laser avec des longueurs d'onde (λ₁, λ₂) différentes.

12. Source de lumière d'excitation EUV (1) selon l'une des revendications 1 à 9, dans laquelle le diviseur de faisceau (2) est un miroir en partie transparent qui présente un revêtement filtrant, lequel est réfléchissant pour un état de polarisation de l'au moins un faisceau laser (12) et où un faisceau (13) séparé et réfléchi est formé, d'une part, et lequel revêtement filtrant est perméable pour un autre état de polarisation de l'au moins un faisceau laser (10) et où un faisceau (12') séparé transmis est produit, d'autre part.

13. Source de lumière d'excitation EUV (1) selon la revendication 12, dans laquelle le faisceau laser (12) incident sur le diviseur de faisceau (2) et le faisceau (13) séparé, réfléchi par le diviseur de faisceau (2) sont disposés dans un premier plan et au moins deux miroirs (4, 5) ou deux lentilles sont disposé (e) s de telle sorte qu'un faisceau (13'') séparé, réfléchi et incident sur le miroir de superposition (3), lequel faisceau (13'') séparé est manipulé par les miroirs (4, 5) ou par les lentilles, et le faisceau (13''') séparé, réfléchi par le miroir de superposition (3) sont disposés dans un deuxième plan et dans laquelle le premier plan et le deuxième plan sont perpendiculaires l'un par rapport à l'autre.

14. Source de lumière d'excitation EUV (1) selon la revendication 12 ou 13 avec au moins deux sources de faisceau laser (9, 9'), dans laquelle les sources de faisceau laser (9, 9') émettent des faisceaux laser dont la polarisation est différente.

15. Source de lumière d'excitation EUV (1) selon la revendication 11 ou 14, dans laquelle les sources de faisceau laser (9, 9') peuvent être pilotées séparément l'une par rapport à l'autre.

16. Source de lumière d'excitation EUV (1) selon l'une des revendications précédentes, dans laquelle la manipulation comprend une modification de la direction d'un faisceau laser (10, 12).

17. Source de lumière d'excitation EUV (1) selon l'une des revendications précédentes, dans laquelle la manipulation comprend une modification de la divergence d'un faisceau laser (10, 12).

18. Procédé destiné à la génération de faisceaux séparés avec une source de lumière d'excitation EUV (1) selon l'une des revendications précédentes, dans lequel le procédé présente les étapes suivantes :
- la détection des positions d'un matériau cible, lesquelles dépendent du temps, pour un « pre-pulse » et un « main-pulse » ;
- le réglage du dispositif de guidage de faisceau (22) de telle sorte que le foyer (7, 8) respectif des deux faisceaux (10'', 11''',12'', 13''') séparés se trouve, pour l'essentiel, dans les positions qui dépendent du temps ;
- le pilotage de la source de faisceau laser (9) de telle sorte que l'au moins un faisceau laser (10, 12) génère le premier foyer (7) et le deuxième foyer (8) à un moment dans le temps où le matériau cible se trouve, pour l'essentiel, dans la position respective qui dépend du temps.

19. Procédé selon la revendication 18, dans lequel les positions qui dépendent du temps sont déterminées de manière empirique et les positions qui dépendent du temps sont réglées de manière fixe par le dispositif de guidage de faisceau (22).

20. Procédé selon la revendication 18, dans lequel les positions qui dépendent du temps sont déterminées pendant un fonctionnement de la source de lumière d'excitation EUV (1) et le dispositif de guidage de faisceau (22) est réglé par un dispositif de commande et dans lequel l'au moins une source de faisceau laser (9) est pilotée.
